# EUROPÄISCHE PATENTANMELDUNG

(11) **EP 1 777 755 A1**
(43) Veröffentlichungstag der Anmeldung: **25.04.2007**
(21) Anmeldenummer: 06017503.1
(22) Anmeldetag: 23.08.2006
(51) Int. Cl.: H01L 33/00

(54) **Leuchtelement mit wenigstens einem Leucht-Chip-Kristall**

(30) Priorität: 22.10.2005 DE 102005050947
(71) Anmelder: Noctron Holding S.A., 8140 Bridel (LU)
(72) Erfinder: Diamantidis, Georg, 56307 Dernbach (DE)
(74) Vertreter: Ostertag, Reinhard

(57) **Zusammenfassung**

Es wird ein Leuchtelement, insbesondere eine Leuchtdiode (1), mit wenigstens einem Leucht-Chip-Kristall (27), insbesondere einem Halbleiterkristall, beschrieben. Wenigstens freie Flächen des Leucht-Chip-Kristalls (27) sind mit einem inerten Material bedeckt. Das inerte Material ist ein flüssiges Fluid (19), welches unmittelbar mit dem Leucht-Chip-Kristall (27) in Kontakt ist.

## Beschreibung

Die Erfindung betrifft ein Leuchtelement, insbesondere eine einer Leuchtdiode ähnliches Leuchtelement, mit wenigstens einem Leucht-Chip-Kristall, insbesondere einem Halbleiterkristall, wobei wenigstens eine freie Fläche des Leucht-Chip-Kristalls mit einem inerten Material bedeckt ist.

Bekannte Leuchtelemente, insbesondere Leuchtdioden, weisen Leucht-Chip-Kristalle aus Halbleiterstrukturen auf, mit denen Licht in einer für die Halbleiterstrukturen charakteristischen Wellenlänge beziehungsweise einem charakteristischen Wellenlängenbereich abgestrahlt wird.

Die Leucht-Chip-Kristalle sind auf Substraten angeordnet und gemeinsam mit diesen in ein transparentes Harz eingegossen. Durch das transparente Harz sind die Leucht-Chip-Kristalle thermisch, elektrisch und mechanisch von der Umgebung, insbesondere gegen die Umgebungsluft, isoliert und geschützt.

Um bekannte Leuchtelemente zu erregen, werden die Leucht-Chip-Kristalle über entsprechende Anschlüsse mit einer Versorgungsspannung beaufschlagt. Hierbei erwärmen sich die Leucht-Chip-Kristalle. Die Versorgungsspannung und damit die Abstrahlungsleistung ist bei bekannten Leuchtelementen insbesondere durch die Hitzebeständigkeit des transparenten Harzes begrenzt. Werden die Leuchtelemente oberhalb einer für sie typischen Versorgungsspannung betrieben, schmilzt das transparente Harz auf Grund der Erwärmung der Leucht-Chip-Kristalle, verfärbt sich insbesondere unter Bildung von Luftbläschen und "stirbt".

Aufgabe der vorliegenden Erfindung ist, ein Leuchtelement der eingangs genannten Art so zu gestalten, dass eine höhere Abstrahlungsleistung und/oder ein größerer Wirkungsgrad bezüglich der Abstrahlung erreichbar ist.

Diese Aufgabe wird erfindungsgemäß dadurch gelöst, dass das inerte Material ein flüssiges Fluid ist, welches unmittelbar mit dem Leucht-Chip-Kristall in Kontakt ist.

Erfindungsgemäß umgibt das Fluid den Leucht-Chip-Kristall isoliert ihn so mechanisch, chemisch und elektrisch von Luft und Umwelt und führt entstehende Wärme ab. Dadurch, dass das Fluid unmittelbar und insbesondere frei von Luft- oder Gasblasen mit dem Leucht-Chip-Kristall in Kontakt steht, wird die Wärme, die bei der Beaufschlagung des Leucht-Chip-Kristalls mit der Versorgungsspannung entsteht, an das Fluid übertragen und mit diesem abtransportiert, so dass der Leucht-Chip-Kristall gekühlt wird.

Hierdurch wird auch ein frühzeitiges Überhitzen des Fluids verhindert, so dass auch dieses sich nicht insbesondere optisch verändert und im schlimmsten Fall "stirbt". Auf diese Weise kann der Leucht-Chip-Kristall bei einer deutlich größeren Versorgungsspannung betrieben werden, als dies bei der Verwendung von Transparentes Harz möglich ist.

Außerdem bewirkt das Kühlen des Leucht-Chip-Kristalls eine deutliche Verbesserung seines Wirkungsgrades bezüglich der Abstrahlung. Insgesamt wird also eine Vergrößerung der Abstrahlungsleistung durch eine größere maximale Versorgungsspannung und/oder die Verbesserung des Wirkungsgrades, auch bei kleiner Versorgungsspannung, erreicht.

Bei einer vorteilhaften Ausführungsform kann das flüssige Fluid wenigstens für das Licht des von dem Leucht-Chip-Kristall abgestrahlten Wellenlängenbereichs transparent sein, so dass das von dem Leucht-Chip-Kristall erzeugte Licht ungehindert durch das Fluid in die Umgebung abgestrahlt werden kann.

Um insbesondere Kriechströme und/oder Reaktionen des Leucht-Chip-Kristalls insbesondere mit der Umgebungsluft zu verhindern, sollte das flüssige Fluid ein guter Spannungs- und Luftisolator sein.

Zweckmäßigerweise kann das flüssige Fluid dickflüssig sein. In dickflüssigem Fluid ist der Leucht-Chip-Kristall besonders gut eingebettet und gegenüber mechanischen Einflüssen, insbesondere Erschütterungen, geschützt.

Damit das flüssige Fluid auch bei Erwärmung seine Form optimal an die Oberfläche des Leucht-Chip-Kristalls anpasst und diese lückenlos bedeckt, sollte das flüssige Fluid seine Viskosität auch bei höheren Temperaturen beibehalten. Außerdem hat dies den Vorteil, dass durch die gleichbleibende, von der Temperatur weitgehend unabhängige Viskosität des flüssigen Fluids auch bei dem strahlend angesteuerten Leucht-Chip, welcher sich dann insbesondere im Bereich des Leucht-Chip-Kristalls stark erwärmt, der Leucht-Chip-Kristall gegen Erschütterungen geschützt ist.

Um einen besonders guten Wärmeabtransport vom Leucht-Chip-Kristall zur Umgebung zu gewährleisten und damit eine Überhitzung des Leucht-Chip-Kristalls und oder des Fluids zu verhindern, sollte das flüssige Fluid ein guter Wärmeleiter sein.

Bei einer weiteren besonders vorteilhafte Ausführungsform kann das flüssige Fluid mit einem Druck beaufschlagt sein. Auf diese Weise wird verhindert, dass sich Luftbläschen an der heißen Oberfläche des Leucht-Chip-Kristalls bilden. Beispielsweise führen Luftbläschen an der Oberfläche von einem mit InGaN als Leucht-Chip-Kristall beschichteten Saphir-Kristall als Substrat, zur sofortigen Verbrennung des Leucht-Chip-Kristalls. Dieser wird im Bruchteil einer Sekunde zerstört und erzeugt somit kein Licht mehr.

Bei einer weiteren besonders vorteilhaften Ausführungsform kann das flüssige Fluid Silikonöl sein. Silikonöl weist alle erforderlichen Eigenschaften des erfindungsgemäßen flüssigen Fluids auf. Es ist darüber hinaus technisch einfach herstellbar und einfach verarbeitbar.

Um mit dem Leucht-Chip blaues Licht im Wellenlängenbereich von 460 nm bis 480 nm erzeugen zu können, kann der Leucht-Chip-Kristall eine Struktur aus InGaN/GaN sein.

Ferner kann das flüssige Fluid die abgestrahlte Wellenlänge beziehungsweise den Wellenlängenbereich beeinflussende Medien, insbesondere Farbstoffe, insbesondere Phosphorkristalle, enthalten. Beispielsweise kann durch Zugabe von Kristallen, die bei Wellenlängen von 450 nm bis 480 nm aktiv sind und blaues in weißes oder gelb-weißes oder rotes oder grünes Licht umwandeln, von dem Leucht-Chip, welcher einen blau strahlenden Leucht-Chip-Kristall aufweist, weißes Licht abgestrahlt werden.

Um mit dem Leucht-Chip Licht im Infraroten, insbesondere im nahen Infrarot, vorzugsweise mit einer Wellenlänge von etwa 850 nm, erzeugen zu können, kann der Leucht-Chip-Kristall eine Struktur aus Infrarot strahlenden Kristallen sein.

Der Leucht-Chip-Kristall kann auf einem Substrat insbesondere Saphir oder Diamant angeordnet sein. Substrate aus Saphir oder Diamant sind technisch einfach realisierbar. Mit Substraten aus Diamant können auch kleinere Leucht-Chip-Kristalle mit einer Ausdehnung von insbesondere 300 µm x 300 µm realisiert werden, mit denen eine höhere Temperatur und ein höherer Wirkungsgrad realisiert werden kann.

Das Leuchtelement kann einen Träger, insbesondere einen Metall- oder Keramikträger, für den Leucht-Chip-Kristall beziehungsweise das Substrat aufweisen. Auf dem Träger ist der Leucht-Chip-Kristall beziehungsweise das Substrat stabil befestigt.

Der Träger, insbesondere der eine Platte aufweisende Metallträger, kann als Reflektor für das von dem Leucht-Chip-Kristall abgestrahlte Licht wirken. Auf diese Weise ist kein separater Reflektor erforderlich, um insbesondere das in Rückwärtsrichtung abgestrahlte Licht in die gewünschte Abstrahlrichtung des Leuchtelementes zu reflektieren.

Um das von dem Leucht-Chip-Kristall erzeugte Licht ohne separate optische Bauteile zu brechen, insbesondere zu bündeln, kann das flüssige Fluid relativ zu dem Leucht-Chip-Kristall so angeordnet ist, dass es für das von dem Leucht-Chip-Kristall abgestrahlte Licht die Wirkung eines optischen Systems, insbesondere einer Linse, hat.

Außerdem kann wenigstens der Leucht-Chip-Kristall von einer optischen Linse, insbesondere einer Glaslinse, abgedeckt und wenigstens der Bereich zwischen dem Leucht-Chip-Kristall und der Linse mit dem flüssigen Fluid gefüllt sein. Auf diese Weise wird die Brechung des von dem Leucht-Chip-Kristall erzeugten Lichtes deutlich verbessert. Die Linse kann auch als Gehäuse für die Leucht-Chip-Kristalle dienen und der Bereich zwischen der Linse und den Leucht-Chip-Kristallen kann mit dem flüssigen Fluid gefüllt sein, so dass kein separates Gehäuse erforderlich ist.

Zweckmäßigerweise kann der Leucht-Chip-Kristall eine Flächenausdehnung zwischen 350 *µ*m x 350 *µ*m und 1050 *µ*m x 1050 *µ*m aufweisen. Bei dieser Größe hat das Leuchtelement einen optimalen Wirkungsgrad bezüglich der Lichtabstrahlung.

Um eine Vergrößerung der Abstrahlungsfläche und somit eine Vergrößerung der Abstrahlungsleistung mit kleinen Strukturbreiten mit einem jeweils optimalen Wirkungsgrad bezüglich der Lichtabstrahlung zu erzielen, kann das Leuchtelement insbesondere eine Hybrid-Struktur aus einer Mehrzahl von insbesondere in Ketten angeordneten Leucht-Chip-Kristallen aufweisen, die in Reihe oder parallel geschaltet sein können. Es kann eine Vielzahl von Ketten, die jeweils aus einer Mehrzahl von in Reihe geschalteten Leucht-Chip-Kristallen zusammengesetzt sind, parallel geschaltet sein. Die Leucht-Chip-Kristalle der Hybrid-Struktur können unterschiedliche Strukturbreiten aufweisen.

Damit das flüssige Fluid nicht vom dem Leucht-Chip-Kristall weg fließt und außerdem das Leuchtelement nach außen hin stabil und geschützt ist, kann der Leucht-Chip-Kristall in einem insbesondere für Licht des von dem Leucht-Chip-Kristall abgestrahlten Wellenlängenbereich transparenten Gehäuse, insbesondere einem Glas- oder Kunststoffgehäuse, angeordnet sein, welches mit dem flüssige Fluid befüllt ist. Durch das für Licht der entsprechenden Wellenlängen transparente Behältnis kann die Strahlung nahezu ungedämpft in die Umgebung abgestrahlt werden.

Das Gehäuse kann ein Mittel zum Einfüllen des flüssigen Fluids aufweisen, so dass es auch nach dem Einbau des Leucht-Chip-Kristalls einfach mit dem Fluid befüllbar ist.

Bei einer weiteren besonders vorteilhaften Ausführungsform kann das Innere des Gehäuses funktionell mit einer Vorkammer verbunden sein, in der sich ein unter einem Druck insbesondere von 1 bis 3 bar stehendes gasförmiges Medium, insbesondere ein Halogen-, Argon-, Neon- und/oder Luft-Gasgemisch, befindet. Auf diese Weise ist einfach und dauerhaft das Fluid mit Druck beaufschlagbar, so dass auch bei höheren Temperaturen des Leucht-Chip-Kristalls an dessen Oberflächen keine Luftblasen entstehen.

Ausführungsbeispiele der Erfindung werden nachfolgend anhand der Zeichnung näher erläutert. Es zeigen:
- Figur 1: schematisch einen seitlichen Schnitt eines ersten Ausführungsbeispiels einer Leuchtdiode mit einer flächigen Anordnung einer Vielzahl von InGaN/GaN-Kristallstrukturen, bei der die InGaN/GaN-Kristallstrukturen in drei parallel geschalteten Ketten jeweils mit drei in Reihe geschalteten InGaN/GaN-Kristallstrukturen in einem Glasgehäuse an-geordnet sind, das mit Silikonöl gefüllt ist, wobei die Anordnung der InGaN/GaN-Kristallstrukturen in der Draufsicht in einem zur restlichen Leuchtdiode vergrößerten Maßstab dargestellt ist;
- Figur 2: eine den Ketten aus Figur 1 ähnliche Kette im Detail, bestehend aus sechs in Reihe geschalteten InGaN/GaN-Kristallstrukturen;
- Figur 3: eine Metall-Trägerplatte mit zu den InGaN/GaN-Kristallstrukturen aus Figur 1 ähnlichen InGaN/GaN-Kristallstrukturen einer der Leuchtdiode aus Figur 1 ähnlichen Leuchtdiode in der Draufsicht;
- Figur 4: schematisch ein zweites Ausführungsbeispiel einer zu der in Figur 1 gezeigten ähnlichen Leuchtdiode, bei der die InGaN/GaN-Kristall-strukturen in einer Hybrid-Struktur bestehend aus vier parallel geschalteten InGaN/GaN-Kristallstrukturen angeordnet sind, wobei die Hybrid-Struktur in der Draufsicht und in einem im Vergleich zur restlichen Leuchtdiode vergrößerten Maßstab dargestellt ist;
- Figur 5: eine der Hybrid-Struktur aus Figur 4 ähnliche Hybrid-Struktur im Detail, wobei hier vier Ketten bestehend aus acht in Reihe geschalteten InGaN/GaN-Kristallstrukturen parallel geschaltet sind;
- Figur 6: eine Metall-Trägerplatte mit einer zu der Hybrid-Struktur aus Figur 4 ähnlichen Hybrid-Struktur einer der Leuchtdiode aus Figur 4 ähnlichen Leuchtdiode in der Draufsicht, wobei die Hybrid-Struktur hier aus drei parallel geschalteten Ketten mit jeweils drei in Reihe geschalteten InGaN/GaN-Kristallstrukturen besteht;
- Figur 7: eine maßstabsgetreue Seitenansicht einer der Leuchtdiode aus Figur 1 ähnlichen Leuchtdiode.

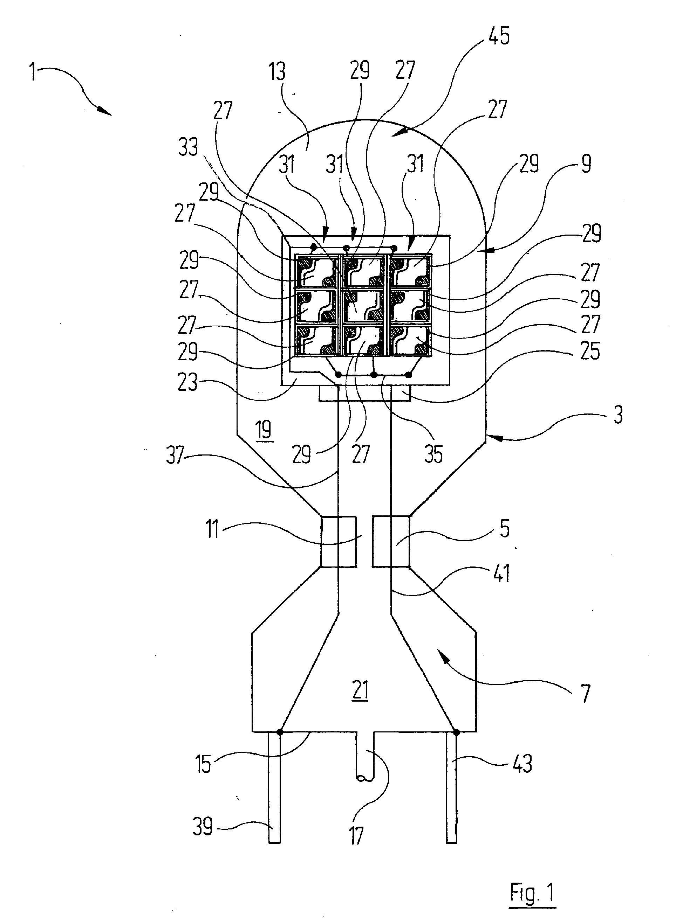

In Figur 1 ist eine insgesamt mit dem Bezugszeichen 1 versehene Leuchtdiode dargestellt. Die Leuchtdiode 1 weist ein hohlzylinderförmiges Gehäuse 3 aus für Licht transparentem Glas auf, dessen Achse in Figur 1 vertikal verläuft.

Das Gehäuse 3 ist über eine horizontale Trennwand 5 in einer Verengung des Gehäuses 3 in eine Vorkammer 7, in Figur 1 unten, und eine Hauptkammer 9, in Figur 1 oben, unterteilt.

In der Trennwand 5 befindet sich mittig ein durchgängiger vertikal verlaufender Kanal 11, über den die Vorkammer 7 mit der Hauptkammer 9 verbunden ist.

Die obere Stirnfläche des Gehäuses 3 ist kugelig, von oben betrachtet konvex geformt und bildet so eine optische Glaslinse 13. Die untere Stirnfläche 15 des Gehäuses 3 ist eben.

In die Vorkammer 7 führt von unten durch die untere Stirnfläche 15 ein Glasröhrchen 17, durch das bei der Herstellung der Leuchtdiode 1 Silikonöl 19 in die Hauptkammer 9 und ein weiter unten näher erläutertes Halogen-Gasgemisch 21 unter Druck in die Vorkammer 7 gefüllt wird.

Im Inneren der Hauptkammer 9 ist ein eine Metallplatte 23 aufweisender Metallträger 25 befestigt. Auf der Metallplatte 23 sind neun InGaN/GaN-Kristallstrukturen 27 jeweils auf einem Saphir-Substrat 29 angeordnet.

Die Metallplatte 23 wirkt als Reflektor für das von den InGaN/GaN-Kristallstrukturen 27 abgestrahlte Licht.

Jede InGaN/GaN-Kristallstruktur 27 weist eine Flächenausdehnung zwischen 350 µm x 350 µm und 1050 µm x 1050 µm auf.

Die InGaN/GaN-Kristallstrukturen 27 auf den Saphir-Substraten 29 sind zur besseren Verdeutlichung ihres Aufbaus in Figur 1 in einer anderen Perspektive gezeigt, nämlich in der Draufsicht, als die restliche Leuchtdiode 1, welche im seitlichen Schnitt dargestellt ist. Außerdem sind sie im Vergleich zur restlichen Leuchtdiode 1 vergrößert gezeigt.

Die InGaN/GaN-Kristallstrukturen 27 sind in drei, in Figur 1 vertikal verlaufenden Ketten 31 mit jeweils drei in Reihe geschalteten InGaN/GaN-Kristallstrukturen 27 angeordnet. Die drei Ketten 31 sind an ihren Enden über eine obere Leitung 33 und eine untere Leitung 35 in Figur 1 oben beziehungsweise unten, verbunden, so dass die Ketten 31 parallel geschaltet sind.

Die obere Leitung 33 führt zu einer linken Anschlußleitung 37, welche durch die Hauptkammer 9, die Trennwand 5, die Vorkammer 7 und die untere Stirnfläche 15 der Vorkammer 7 hindurch nach unten führt. Sie ist mit einem linken Anschlußstift 39, der in Figur 1 unten aus dem Gehäuse 3 ragt, verbunden. Der linke Anschlußstift 39 ist mit einer nicht dargestellten Spannungsversorgungseinrichtung für die Leuchtdiode 1 verbindbar.

Die untere Leitung 35 führt anlog zur oberen Leitung 37 über eine rechte Anschlußleitung 41 zu einem rechten Anschlußstift 43.

Die Hauptkammer 9 ist vollständig mit transparentem Silikonöl 19 gefüllt, welches bei der Herstellung der Leuchtdiode 1 über das Glasröhrchen 17 eingefüllt wird. Die InGaN/GaN-Kristallstrukturen 27 mit den Saphir-Substraten 29 sind vollständig in das Silikonöl 19 eingetaucht. Alle freien Oberflächen der InGaN/GaN-Kristallstrukturen 27 sind so unmittelbar und blasenfrei, mit Silikonöl 19 in Kontakt. Auch die freien Oberflächen der Saphir-Substrate 29 sind mit Silikonöl 19 bedeckt.

Das Silikonöl 19 ist ein guter Wärmeleiter. Mit dem Silikonöl 19 werden die InGaN/GaN-Kristallstrukturen 27 und die Saphir-Substrate 29 gekühlt und die Wärme von diesen weg nach außen an die Innenflächen des Gehäuses 3 abgeführt, so dass die InGaN/GaN-Kristallstrukturen 27 und das Silikonöl 19 an den Oberflächen insbesondere der InGaN/GaN-Kristallstrukturen 27 nicht überhitzt werden.

Die Glaslinse 13 und das Silikonöl 19 in dem Bereich zwischen dem InGaN/GaN-Kristallstrukturen 27 und der Glaslinse 13 bilden ein optisches System 45, mit dem das mit den InGaN/GaN-Kristallstrukturen 27 erzeugte Licht gestreut wird.

Ferner ist das Silikonöl 19 ein guter Spannungs- und - Luftisolator, so dass es die InGaN/GaN-Kristallstrukturen 27 und die Saphir-Substrate 29 elektrisch und chemisch von der Umgebung isolieren.

Im Übrigen ist das Silikonöl 19 dickflüssig und schützt so die InGaN/GaN-Kristallstrukturen 27 und die Saphir-Substrate 29 gegen mechanische Einflüsse, beispielsweise dämpft es gegen Erschütterungen. Es behält seine Viskosität auch bei höheren Temperaturen bei, so dass die Leuchtdiode 1, insbesondere die InGaN/GaN-Kristall-strukturen 27, auch im Betrieb, wenn sie erwärmt sind, gut geschützt ist.

In der Vorkammer 7 befindet sich das unter einem Druck von 1 bis 3 bar stehende Halogen-Gasgemisch 21. Über den Kanal 11 wird so auch das Silikonöl 19 mit Druck beaufschlagt.

Zum Betreiben der Leuchtdiode 1 wird an die Anschlußstifte 39 und 43 eine zur Erzeugung der gewünschten Helligkeit geeignete Versorgungsspannung angelegt.

Bekannte InGaN/GaN-Kristallstrukturen auf Saphir-Sub-straten arbeiten ohne die Verwendung von Silikonöl derzeit mit einer Mindest-Versorgungsspannung von 3,02 V bis maximal 3,2 V und strahlen blau im Wellenlängenbereich von 460 nm bis 480 nm. Wenn die InGaN/GaN-Kristall-strukturen auf Saphir-Substraten in transparentes Harz eingegossen sind, wie dies derzeit üblich ist, sind sie mit maximal 5,8 V bis 6,5 V belastbar und strahlen Blaulicht mit einer Wellenlänge unterhalb von 460 nm bis 475 nm aus. Bei dieser Spannung fängt das Transparentes Harz an zu schmelzen, verfärbt sich gelb unter Entstehung von Luftbläschen und "stirbt".

Die Wärmeleitung des Silikonöls 19 bei der vorgeschlagenen Leuchtdiode 1 bewirkt, dass die InGaN/GaN-Kristall-strukturen 27 im Unterschied zu den bekannten von trans-parentem Harz umgebenen Kristallstrukturen hier mit Versorgungsspannungen bis zu 28 V belastet werden können, obwohl dieselben InGaN/GaN-Kristallstrukturen laut Hersteller derzeit bei bekannten Leuchtdioden bei einer falschen Polungsbahnung von 5 V bis 6 V "sterben".

Obwohl die InGaN/GaN-Kristallstrukturen 27 lediglich für eine Versorgungsspannung von 5 V bis 6 V ausgelegt sind, halten diese erfindungsgemäß in Silikonöl 19 eingetaucht eine Versorgungsspannung von über 25 V aus, ohne beispielsweise zu verbrennen.

Dadurch, dass das Silikonöl 19 bei der vorgeschlagenen Leuchtdiode 1 mit einem Druck beaufschlagt ist, bilden sich auch bei etwa 28 V keine Luftbläschen und die InGaN/GaN-Kristallstrukturen 27 sind selbst bei solch hohen Versorgungsspannung noch betreibbar. Die Lichtausbeute bei dieser, auch über dem Üblichen liegenden, Versorgungsspannung im Bereich von 3 V bis 18 V ist sehr hoch.

Erst ab 18 V nehmen die InGaN/GaN-Kristallstrukturen 27 mehr Strom auf, ohne mehr Licht zu erzeugen. Somit ist eine längere Betriebszeit der InGaN/GaN-Kristall-strukturen 27, welche in transparentes Silikonöl 19 ein-tauchen sind und sehr gute Lichtintensität ausstrahlen, mit einer bevorzugten Versorgungsspannung zwischen 3 V und 18 V möglich.

Die oben angegeben Spannungswerte sind lediglich beispielhaft für die verwendeten InGaN/GaN-Kristall-strukturen 27, für andere Kristallstrukturen können andere Versorgungsspannungen erforderlich sein. Für die Erfindung wesentlich ist aber, dass durch die Verwendung des Silikonöls 19 beziehungsweise einer anderen geeig-neten inerten Flüssigkeit auch an Stelle der InGaN/GaN-Kristallstrukturen 27 verwendete Leucht-Chip-Kristalle bei höheren Spannungen und/oder mit höheren Wirkungsgraden bezüglich der Lichtausbeute betrieben werden können als dies mit derzeitig bekannten Ummantelungen, beispielsweise mit transparentem Harz, möglich ist.

Um weißes Licht zu erzeugen, sind dem Silikonöl 19 Phosphorkristalle oder andere Kristalle, die bei Wellenlängen von 450 nm bis 480 nm aktiv sind, zugesetzt, mit denen blaues in weißes oder gelb-weißes oder rotes oder grünes Licht umgewandelt wird.

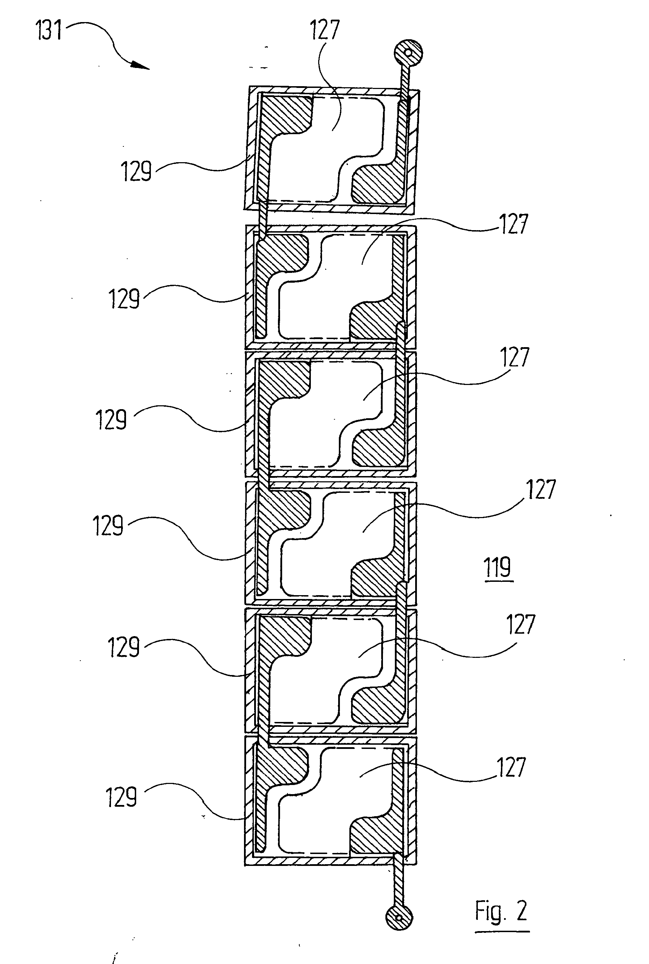

In Figur 2 ist eine den Ketten 31 aus Figur 1 ähnliche Kette 131 bestehend aus sechs in Reihe geschalteten InGaN/GaN-Kristallstrukturen 127 auf Saphir-Substraten 129 im Detail gezeigt, die in Silikonöl 119 eingetaucht sind.

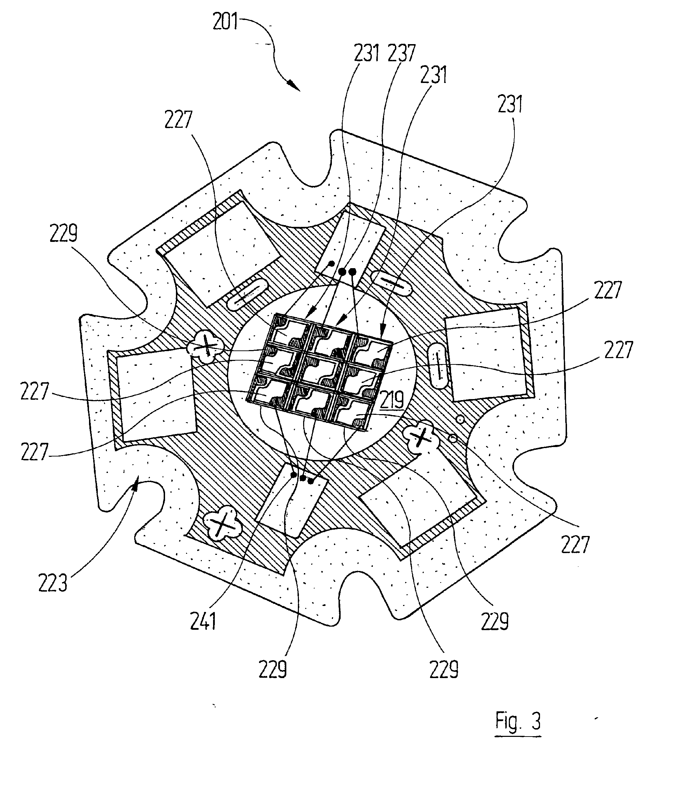

In Figur 3 ist eine Metall-Trägerplatte 223 mit zu den InGaN/GaN-Kristallstrukturen 27 aus Figur 1 ähnlichen InGaN/GaN-Kristallstrukturen 227 einer der Leuchtdiode 1 aus Figur 1 ähnlichen Leuchtdiode 201 in der Draufsicht dargestellt. Diejenigen Elemente, die zu denen in Verbindung mit Figur 1 beschriebenen ähnlich sind, sind mit den selben Bezugszeichen zuzüglich 200 versehen, so dass bezüglich deren Beschreibung auf die dortigen Ausführungen Bezug genommen wird.

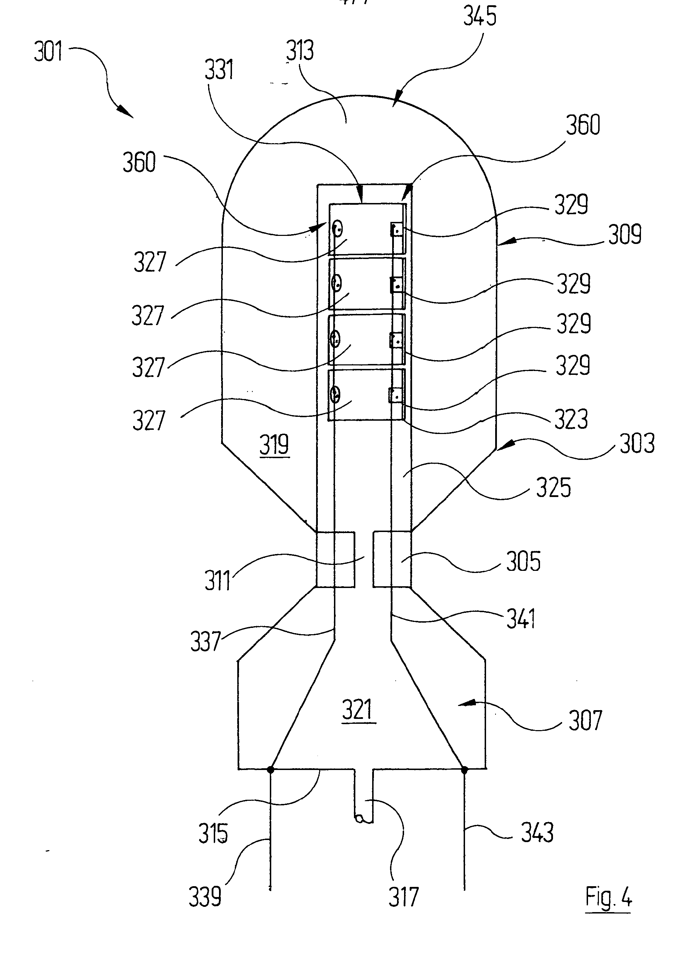

Bei einem weiteren Ausführungsbeispiel einer Leuchtdiode 301, dargestellt in Figur 4, sind diejenigen Elemente, die zu denen des ersten, in Figur 1 beschriebenen Ausführungsbeispiel ähnlich sind, mit den selben Bezugszeichen zuzüglich 300 versehen, so dass bezüglich deren Beschreibung auf die Ausführungen zum ersten Ausführungsbeispiel Bezug genommen wird.

Diese Ausführungsbeispiel unterscheidet sich von dem ersten dadurch, dass die Leuchtdiode 301 als eine Hybrid-Struktur 360 aus einer Mehrzahl von in einer Kette 331 angeordneten InGaN/GaN-Kristallstrukturen 327 aufgebaut ist. Die InGaN/GaN-Kristallstrukturen 327 sind in Reihe geschaltet.

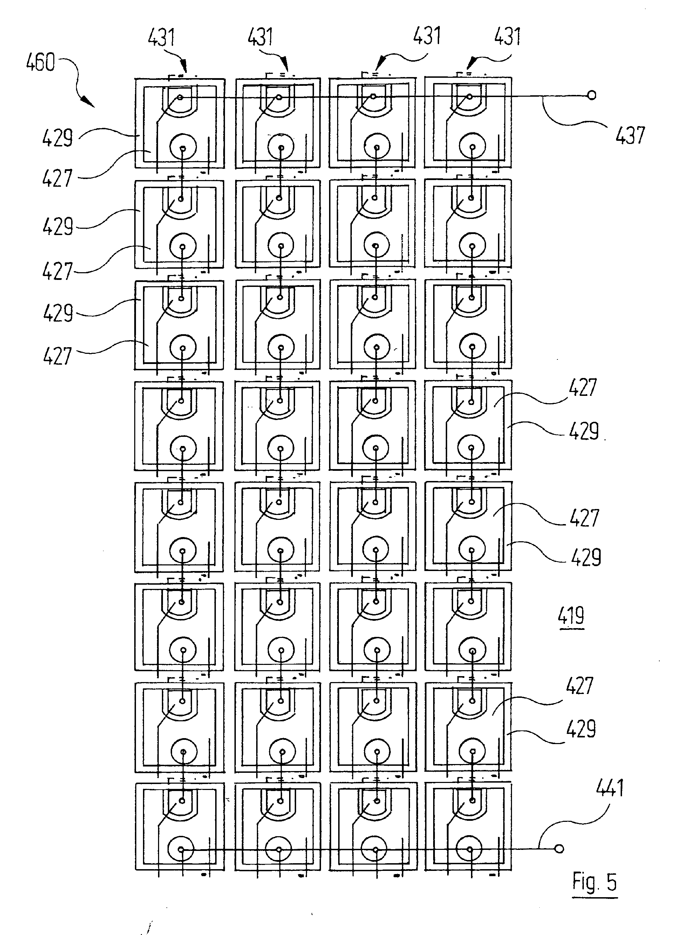

In Figur 5 ist eine der Hybrid-Struktur 360 aus Figur 4 ähnliche Hybrid-Struktur 460 im Detail gezeigt, wobei hier vier Ketten 431 bestehend aus acht in Reihe geschalteten InGaN/GaN-Kristallstrukturen 427 auf Saphir-Substraten 429 parallel geschaltet sind und in Silikonöl 419 eintauchen.

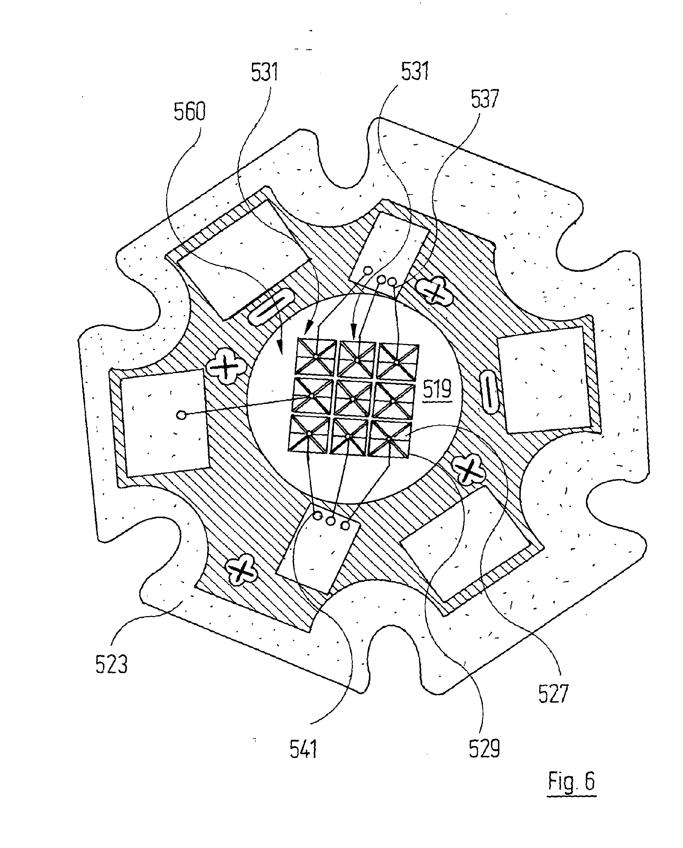

In Figur 6 eine Metall-Trägerplatte 523 mit einer zu der Hybrid-Struktur 460 aus Figur 4 ähnlichen Hybrid-Struktur 560 einer der Leuchtdiode 301 aus Figur 4 ähnlichen Leuchtdiode in der Draufsicht dargestellt. Die Hybrid-Struktur 560 ist in Silikonöl 519 eingetaucht. Sie besteht hier aus drei parallel geschalteten Ketten 531 mit jeweils drei in Reihe geschalteten InGaN/GaN-Kristall-strukturen 527 auf Saphir-Substraten 529. Von der Hybrid-Struktur 560 führen Anschlußleitungen 541 und 537 zu nicht dargestellten Anschlußstiften der Leuchtdiode.

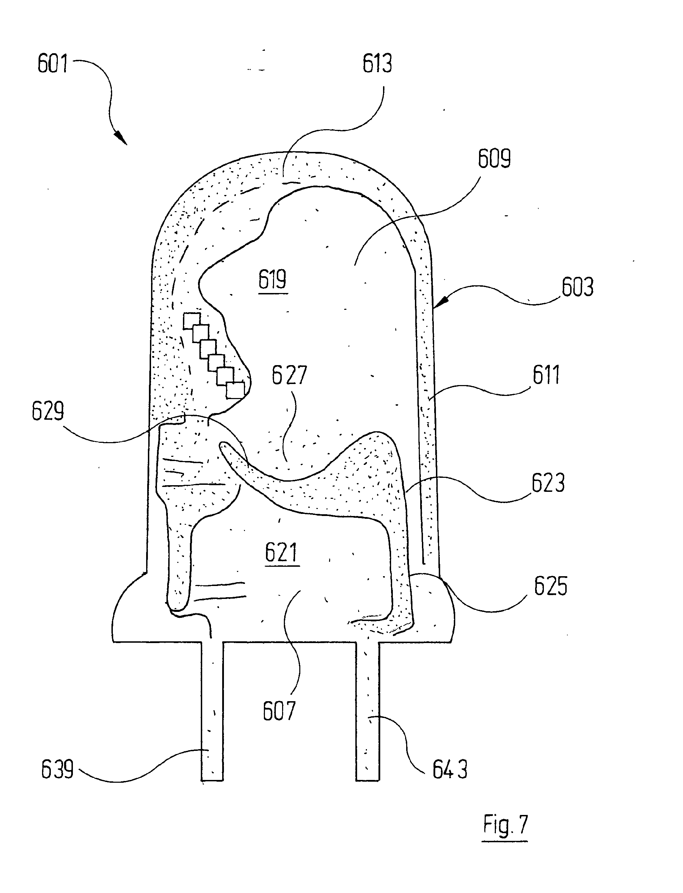

Figur 7 zeigt eine maßstabsgetreue Seitenansicht einer der Leuchtdiode 1 aus Figur 1 ähnlichen Leuchtdiode 601. Diejenigen Elemente, die zu in Verbindung mit Figur 1 beschriebenen ähnlich sind, sind mit denselben Bezugszeichen zuzüglich 600 versehen, so dass bezüglich deren Beschreibung auf die dortigen Ausführungen Bezug genommen wird.

Die Leuchtdiode 601 weist keine Verengung zwischen der Vorkammer 607 und der Hauptkammer 609 auf. Der Kanal 611 führt hier in einem Randbereich des Gehäuses 603, in Figur 7 rechts, von unten bis zur oberen Stirnseite der Leuchtdiode 601.

Anstelle der Leuchtdiode 1; 301 kann auch ein andersartiges Leuchtelement realisiert sein.

Statt einer Mehrzahl von InGaN/GaN-Kristallstrukturen 27; 127; 227; 327; 427; 527; 627 kann die Leuchtdiode 1; 301 oder das Leuchtelement auch nur eine einzige Kristallstruktur aufweisen.

Statt der InGaN/GaN-Kristallstrukturen 27; 127; 227; 327; 427; 527; 627 können auch andersartige Leucht-Chip-Kristalle, insbesondere Halbleiterkristalle, beispielsweise infrarot strahlende Kristallstrukturen, die insbesondere mit einer Wellenlänge von 850 nm strahlen, eingesetzt werden.

Die InGaN/GaN-Kristallstrukturen 27; 127; 227; 327; 427; 527; 627 mit den Saphir-Substraten 29; 129; 229; 329; 429; 529; 629 muss nicht vollständig in das Silikonöl 19; 119; 219; 319; 419; 519; 619 eingetaucht sein. Es können auch nur die freien Flächen der InGaN/GaN-Kristallstrukturen 27; 127; 227; 327; 427; 527; 627 mit dem Silikonöl 19; 119; 219; 319; 419; 519; 619 bedeckt sein.

Statt dem Silikonöl 19; 119; 219; 319; 419; 519; 619 kann auch ein anderes inertes flüssiges Fluid verwendet werden.

Das flüssige Fluid, insbesondere das Silikonöl 19; 119; 219; 319; 419; 519; 619, kann statt dickflüssig auch dünnflüssig sein.

Es kann auch ein flüssiges Fluid verwendet werden, das seine Viskosität bei höheren Temperaturen verändert.

Im Übrigen kann das Silikonöl 19; 119; 219; 319; 419; 519; 619 auch nur für das Licht des von dem Leucht-Chip-Kristall abgestrahlten Wellenlängenbereichs transparent sein.

Das flüssige Fluid, insbesondere das Silikonöl 19; 119; 219; 319; 419; 519; 619, muss nicht mit einem Druck beaufschlagt sein, es kann auch den Umgebungsdruck aufweisen.

Das flüssige Fluid, insbesondere das Silikonöl 19; 119; 219; 319; 419; 519; 619, kann statt der Phosphorkristalle auch andere, die abgestrahlte Wellenlänge beziehungsweise den Wellenlängenbereich beeinflussende Medien, deren Licht extrahiert wird, insbesondere Kristalle, oder gar keine Zusätze enthalten. Sind keine Zusätze im Silikonöl 19; 119; 219; 319; 419; 519; 619 enthalten stahlen die InGaN/GaN-Kristallstrukturen 27; 127; 227; 327; 427; 527; 627 blaues Licht im Wellenlängenbereich zwischen 460 nm und 475 nm aus.

Der Leucht-Chip-Kristall, insbesondere die InGaN/GaN-Kristallstrukturen 27; 127; 227; 327; 427; 527; 627, kann statt auf einem Saphir-Substrat 29; 129; 229; 329; 429; 529; 629 auch auf einem andersartigen Substrat, vorzugsweise einem Substrat aus Diamant, angeordnet sein. Hiermit können auch kleinere Leucht-Chip-Kristalle mit einer Ausdehnung von insbesondere 300 *µ*m x 300 *µ*m realisiert werden.

Anstelle des Metallträgers 25; 325; 625 kann auch ein Keramikträger für den Leucht-Chip-Kristall beziehungsweise das Substrat eingesetzt werden. Der Metallträger 25; 325; 625 kann statt als Platte 23; 223; 323; 523; 623 auch in einer anderen Form ausgebildet sein.

Das Silikonöl 19; 119; 219; 319; 419; 519; 619 muss nicht notwendigerweise so angeordnet sein, dass es die Wirkung eines optischen Systems hat.

Statt nur der einen Glaslinse 13; 313 kann auch eine Linsenanordnung oder auch gar keine Linse vorgesehen sein. Es kann statt der Glaslinse 13; 313 auch ein Linse aus einem anderen Material, beispielsweise aus Kunststoff, verwendet werden. Die Linse kann auch über die Leucht-Chip-Kristalle gestülpt sein, welche beispielsweise auf einer Trägerplatte angeordnet sind. So wirkt die Linse als Gehäuse und der Bereich zwischen der Linse und den Leucht-Chip-Kristallen kann mit dem flüssigen Fluid gefüllt werden.

Die Leucht-Chip-Kristalle, insbesondere die einzelnen InGaN/GaN-Kristallstrukturen 27; 127; 227; 327; 427; 527; 627 können auch eine Flächenausdehnung aufweisen, die kleiner als 350 µm x 350 µm oder größer als 1050 µm x 1050 µm ist.

Die InGaN/GaN-Kristallstrukturen 27; 127; 227; 327; 427; 527; 627 mit den Saphir-Substraten 29; 129; 229; 329; 429; 529; 629 auf der Metallplatte 23; 223; 323; 523; 623 des Metallträgers 25; 325; 625 können statt in dem Gehäuse 3; 303; 603 aus Glas auch in einem andersartigen und/oder einem andersförmigen Gehäuse, beispielsweise einem Kunststoffgehäuse angeordnet sein. Das Gehäuse 3; 303; 603 kann auch nur die InGaN/GaN-Kristallstrukturen 27; 127; 227; 327; 427; 527; 627 mit dem flüssigen Fluid umschließen. Das Gehäuse 3; 303; 603 kann auch nur für Licht des von den InGaN/GaN-Kristallstrukturen 27; 127; 227; 327; 427; 527; 627 abgestrahlten Wellenlängenbereichs transparent sein.

Anstelle des Glasröhrchens 17; 317 kann das Gehäuse 3; 303 auch ein andersartiges Mittel zum Einfüllen des flüs-sigen Fluids, insbesondere des Silikonöls 19; 119; 219; 319; 419; 519; 619, und/oder des Halogen-Gasgemischs 21; 321; 621 beziehungsweise eines anderen Gasgemischs, beispielsweise einen Kunststoffschlauch oder lediglich eine Öffnung, auch an einer anderen Stelle des Gehäuses 3; 303; 603 aufweisen. Es können für das flüssige Fluid und das Gasgemisch auch unterschiedliche Mittel zum Befüllen vorgesehen sein.

Statt lediglich eines Kanals 11; 211; 311; 511; 611 können auch mehrere Kanäle die Vorkammer 7; 307; 607 mit dem Inneren des Gehäuses 3; 303; 603 verbinden.

Anstelle des Halogen-Gasgemischs 21; 321; 621 kann auch ein andersartiges, unter Druck stehendes gasförmiges Medium, beispielsweise ein Argon-, Neon- und/oder Luft-Gasgemisch, in der Vorkammer 7; 307; 607 sein. Der Druck kann auch kleiner als 1 bar oder größer als 3 bar sein.

## Patentansprüche

**1.** Leuchtelement, mit wenigstens einem Leucht-Chip-Kristall (27; 127; 227;327; 427; 527; 627), insbesondere einem Halbleiterkristall, wobei wenigstens eine freie Fläche des Leucht-Chip-Kristalls mit einem inerten Material in Kontakt steht, **dadurch gekennzeichnet, dass** das inerte Material ein flüssiges Fluid (19; 119; 219; 319; 419; 519; 619) ist, welches mit dem Leucht-Chip-Kristall (27; 127; 227; 327; 427; 527; 627) in Kontakt steht.

**2.** Leuchtelement nach Anspruch 1, **dadurch gekennzeichnet,**
**dass** das flüssige Fluid (19; 119; 219; 319; 419; 519; 619) wenigstens für das Licht des von dem Leucht-Chip-Kristall (27; 127; 227; 327; 427; 527; 627) abgestrahlten Wellenlängenbereichs transparent ist.

**3.** Leuchtelement nach einem der vorherigen Ansprüche,
**dadurch gekennzeichnet, dass** das flüssige Fluid(19; 119; 219; 319; 419; 519; 619) ein guter Spannungs- und Luftisolator ist.

**4.** Leuchtelement nach einem der vorherigen Ansprüche,
**dadurch gekennzeichnet, dass** das flüssige Fluid (19; 119; 219; 319; 419; 519; 619) dickflüssig ist.

**5.** Leuchtelement nach einem der vorherigen Ansprüche,
**dadurch gekennzeichnet, dass** das flüssige Fluid (19; 119; 219; 319; 419; 519; 619) seine Viskosität auch bei höheren Temperaturen beibehält.

**6.** Leuchtelement nach einem der vorherigen Ansprüche,
**dadurch gekennzeichnet, dass** das flüssige Fluid (19; 119; 219; 319; 419; 519; 619) ein guter Wärmeleiter ist.

**7.** Leuchtelement nach einem der vorherigen Ansprüche,
**dadurch gekennzeichnet, dass** das flüssige Fluid (19; 119; 219; 319; 419; 519; 619) mit einem Druck beaufschlagt ist.

**8.** Leuchtelement nach einem der vorherigen Ansprüche,
**dadurch gekennzeichnet, dass** das flüssige Fluid Silikonöl (19; 119; 219; 319; 419; 519; 619) ist.

**9.** Leuchtelement nach einem der vorherigen Ansprüche,
**dadurch gekennzeichnet, dass** der Leucht-Chip-Kristall (27; 127; 227; 327; 427; 527; 627) eine Struktur aus InGaN/GaN ist.

**10.** Leuchtelement nach einem der Ansprüche 1 bis 8, **dadurch**
**gekennzeichnet, dass** das flüssige Fluid (19; 119; 219; 319; 419; 519; 619) die abgestrahlte Wellenlänge beziehungsweise den Wellenlängenbereich beeinflussende Medien, insbesondere Farbstoffe, insbesondere Phosphorkristalle, enthält.

**11.** Leuchtelement nach einem der Ansprüche 1 bis 8, **dadurch**
**gekennzeichnet, dass** der Leucht-Chip-Kristall eine Struktur aus infrarot strahlenden Kristallen ist.

**12.** Leuchtelement nach einem der vorherigen Ansprüche,
**dadurch gekennzeichnet, dass** der Leucht-Chip-Kristall (27; 127; 227; 327; 427; 527; 627) auf einem Substrat insbesondere Saphir (29; 129; 229; 329; 429; 529; 629) oder Diamant angeordnet ist.

**13.** Leuchtelement nach einem der vorherigen Ansprüche,
**gekennzeichnet durch** einen Träger (25; 325; 625), insbesondere einen Metall- oder Keramikträger, für den Leucht-Chip-Kristall (27; 127; 227; 327; 427; 527; 627) beziehungsweise das Substrat (29; 129; 229; 329; 429; 529; 629).

**14.** Leuchtelement nach Anspruch 13, **dadurch gekennzeichnet,**
**dass** der Träger, insbesondere der eine Platte (23; 223; 323; 523; 623) aufweisende Metallträger (25; 325; 625), als Reflektor für das von dem'Leucht-Chip-Kristall (27; 127; 227; 327; 427; 527; 627) abgestrahlte Licht wirkt.

**15.** Leuchtelement nach einem der vorherigen Ansprüche,
**dadurch gekennzeichnet, dass** das flüssige Fluid (19; 119; 219; 319; 419; 519; 619) relativ zu dem Leucht-Chip-Kristall so angeordnet ist, dass es für das von dem Leucht-Chip-Kristall (27; 127; 227; 327; 427; 527; 627) abgestrahlte Licht die Wirkung eines optischen Systems, insbesondere einer Linse, hat.

**16.** Leuchtelement nach einem der vorherigen Ansprüche,
**dadurch gekennzeichnet, dass** wenigstens der Leucht-Chip-Kristall (27; 127; 227; 327; 427; 527; 627) von einer optischen Linse, insbesondere einer Glaslinse (13; 313; 613), abgedeckt und wenigstens der Bereich zwischen dem Leucht-Chip-Kristall (27; 127; 227; 327; 427; 527; 627) und der Linse mit dem flüssigen Fluid (19; 119; 219; 319; 419; 519; 619) gefüllt ist.

**17.** Leuchtelement nach einem der vorherigen Ansprüche,
**dadurch gekennzeichnet, dass** der Leucht-Chip-Kristall (27; 127; 227; 327; 427; 527; 627) eine Flächenausdehnung zwischen 350 *µ*m x 350 *µ*m und 1050 *µ*m x 1050 *µ*m aufweist.

**18.** Leuchtelement nach einem der vorherigen Ansprüche,
**dadurch gekennzeichnet, dass** er eine Hybrid-Struktur (360; 460; 560) aus einer Mehrzahl von insbesondere in Ketten (331; 431; 531) angeordneten Leucht-Chip-Kristallen (327; 427; 527), aufweist, die in Reihe oder parallel geschaltet sind.

**18.** Leuchtelement nach einem der vorherigen Ansprüche,
**dadurch gekennzeichnet, dass** der Leucht-Chip-Kristall (27; 127; 227; 327; 427; 527; 627) in einem insbesondere für Licht des von dem Leucht-Chip-Kristall (27; 127; 227; 327; 427; 527; 627) abgestrahlten Wellenlängenbereich transparenten Gehäuse (3; 303; 603), insbesondere einem Glasoder Kunststoffgehäuse, angeordnet ist, welches mit dem flüssige Fluid (19; 119; 219; 319; 419; 519; 619) befüllt ist.

**19.** Leuchtelement nach Anspruch 19, **dadurch** gekennzeich-net,
dass das Gehäuse (3; 303; 603) ein Mittel (17; 317) zum Einfüllen des flüssigen Fluids (19; 119; 219; 319; 419; 519; 619) aufweist.

**20.** Leuchtelement nach Anspruch 19 oder 20, **dadurch**
**gekennzeichnet, dass** das Innere des Gehäuses (3; 303; 603) funktionell mit einer Vorkammer (7; 307; 607)verbunden ist, in der sich ein unter einem Druck insbesondere von 1 bis 3 bar stehendes gasförmiges Medium (21; 321; 621), insbesondere ein Halogen-, Argon-, Neon- und/oder Luft-Gasgemisch, befindet.
